Europäisches Patentamt

European Patent Office

Office européen des brevets

(11) Numéro de publication: **0 171 308**
**B1**

(12) **FASCICULE DE BREVET EUROPEEN**

(45) Date de publication du fascicule du brevet: **14.11.90**

(21) Numéro de dépôt: **85401320.8**

(22) Date de dépôt: **28.06.85**

(51) Int. Cl.⁵: **G 06 F 15/20**

(54) Dispositif de simulation de la défaillance ou du bon fonctionnement d'un système logique.

(30) Priorité: **03.07.84 FR 8410516**

(43) Date de publication de la demande:
**12.02.86 Bulletin 86/07**

(45) Mention de la délivrance du brevet:
**14.11.90 Bulletin 90/46**

(84) Etats contractants désignés:
**BE DE GB IT NL**

(56) Documents cités:
**FR-A-2 030 438**
**US-A-3 649 910**
**US-A-3 702 011**

**IEEE TRANSACTIONS ON RELIABILITY, vol.
R-29, no. 1, avril 1980, pages 2-9, IEEE, New
York, US; P.K. ANDOW: "Difficulties in fault-tree
synthesis for process plant"**

(73) Titulaire: **COMMISSARIAT A L'ENERGIE
ATOMIQUE
31/33, rue de la Fédération
F-75015 Paris (FR)**

(72) Inventeur: **Laviron, André
15, rue des Champs Viaux Daix
F-21121 Fontaine les Dijon (FR)**

(74) Mandataire: **Mongrédien, André et al
c/o BREVATOME 25, rue de Ponthieu
F-75008 Paris (FR)**

Courier Press, Leamington Spa, England.

## Description

La présente invention concerne un dispositif de simulation de la défaillance ou du bon fonctionnement d'un système logique. Ce dispositif permet de simuler un système comprenant une pluralité de composants logiques interconnectés, en soumettant ces composants à des événements tels que des défaillances ou des réparations; ces événements sont simulés par des signaux logiques de niveau 0 et de niveau 1 combinés, en séquences. Ces signaux de simulation permettent de déterminer les séquences pour lesquelles la mise en état de défaillance de bon fonctionnement d'un ou plusieurs composants du système, entraînent la défaillance ou le bon fonctionnement du système ou réciproquement.

On sait que pour simuler la défaillance ou le bon fonctionnement d'un système mécanique, hydraulique, etc., il est souvent nécessaire de remplacer ce système par un dispositif de simulation comprenant un ensemble de moyens logiques équivalant aux composants du système; chacun de ces moyens comprend des entrées de simulation, sur lesquelles sont appliqués des signaux de simulation, dont les états logiques représentent respectivement soit la défaillance, soit le bon fonctionnement du composant que l'on souhaite simuler. Ces moyens logiques sont interconnectés de manière que sur une sortie commune, le signal résultant de la simulation des défaillances ou des bons fonctionnements des différents composants, présente un état logique correspondant soit à l'état de défaillance, soit à l'état de bon fonctionnement du système simulé.

En fait, le dispositif de l'invention permet de simuler tous les systèmes pouvant fonctionner à partir de la réception en séquence de signaux logiques combinés de niveau 0 ou 1.

On sait que la défaillance ou le bon fonctionnement des composants d'un système peut être simulé par des signaux intervenant soit simultanément, soit séparément. L'étude de la défaillance d'un système se fait, en appliquant à des entrées d'un dispositif de simulation, des signaux de niveau 0 ou 1, pour simuler la défaillance (panne) ou le bon fonctionnement (réparation) des composants correspondants du système. Pour chacune des combinaisons de signaux logiques de simulation appliqués sur les entrées du dispositif de simulation, la réponse du dispositif (niveau logique 0 ou 1 du signal de sortie de ce dispositif) est analysée, afin de savoir s'il s'agit d'une combinaison de signaux logiques entraînant ou non la défaillance du système. La liste des combinaisons de signaux logiques de niveau 0 ou 1 associées aux réponses du dispositif, permet d'analyser le système simulé, pour des études de fiabilité.

Ces dispositifs du simulation sont particulièrement utiles dans les centrales nucléaires, les avions, les ensembles de recherches pétrolières,... dans lesquels il est nécessaire de mettre en oeuvre des systèmes de commande ou de sécurité présentant une grande fiabilité et ayant très souvent pour cette raison, des voies redondantes. Ces voies redondantes permettent d'éviter que toute panne de l'un des composants de l'une des voies empêche le système de déclencher l'action de sécurité ou de commande souhaitée. Ces voies redondantes permettent aussi de réparer ou contrôler une ou plusieurs voies, sans empêcher l'action de sécurité ou de commande souhaitée pendant ce contrôle ou cette réparation.

Différentes méthodes ont été utilisées pour analyser la fiabilité de systèmes de commande ou de sécurité. Malheureusement, ces méthodes utilisent généralement le principe dit "d'arbre de défaillance", qui nécessite l'usage d'un calculateur de puissance, lorsque le système à contrôler est complexe. Ces difficultés sont décrites dans l'article de P. K. Andow intitulé "Difficulties in fault tree systhesis for process plant" paru dans la revue IEEE transactions reliability, vol. R 29, avril 1980, pages 2 à 9.

Les difficultés qui apparaissent dans l'analyse de fiabilité d'un système à partir de l'arbre de défaillance de ce système peuvent être surmontées grâce à l'utilisation de circuits ou dispositifs de simulation câblés, équivalant au système à analyser. Ces circuits sont décrits, par exemple dans l'article intitulé "Vérification of fault tree analysis" publié par "Electric Power Research Institute" dans la revue EPRI-NP-1570, vol. 1 et 2, mai 1981. Ces circuits ou dispositifs de simulation permettent d'éviter la conception d'un arbre de défaillance d'un système; ils sont cependant très limités en performances, puisqu'ils permettent l'étude de fiabilité de systèmes comportant au plus 20 composants.

Un autre système utilisant un calculateur de simulation est décrit dans le brevet US—A—3 702 011. Le système décrit dans ce brevet permet uniquement de simuler les fautes dans un circuit logique. Ce système permet de simuler des fautes de fonctionnement des composants du circuit logique et fournit sur une sortie un état de fonctionnement du circuit, et plus particulièrement un dictionnaire comprenant tous les symptômes relatifs aux fautes. A cet effet, le circuit logique à simuler est subdivisé en blocs; des représentations numériques des interconnexions dans chaque bloc sont enregistrées dans des tables de données d'un calculateur de simulation. Chaque bloc est alors simulé en calculant les erreurs de sortie qui pourraient être fournies par ce bloc, en réponse à des signaux de simulation. Les résultats de simulation sont inscrits dans une liste indiquant les fautes du système de manière à constituer un dictionnaire comprenant tous le symptômes relatifs aux fautes.

Ce système exige un ordinateur présentant une grande puissance de calcul, car il est nécessaire de dresser une représentation numérique des composants et de dresser une liste des fautes ou défaillances.

Plus récemmment a été développé un générateur de signaux logiques combinés permettant d'étudier la fiabilité de systèmes à partir de circuits ou dispositifs de simulation. Ce générateur est décrit dans l'article de A. Laviron, intitulé "ESCAF"—Failure Simulation and Reliability Calculation Device"—Second National Reliability Conference—Birmingham (England), vol. 2, mars 1979, pages 6C/4/1—6C/4/10. Ce générateur de signaux logiques combinés permet d'étudier la fiabilité de systèmes complexes, par l'intermédiaire de dispositifs ou circuits simulateurs logiques. Il fournit sur N de ses sorties, toutes les combinaisons possibles de P signaux logiques de niveau 1 et de N—P signaux logiques de niveau 0. Ces signaux logiques sont appliqués, en fonction des tests recherchés de fiabilité, sur les entrées des composants du dispositifs de simulation, de manière à simuler soit le bon fonctionnement de chaque composant par exemple, (niveau logique 1 du signal appliqué sur une entrée du composant), soit la défaillance de chaque composant (niveau logique 0 appliqué sur l'entrée de ce composant). Ce signaux logiques simulant la défaillance ou le bon fonctionnement d'un ou plusieurs composants du système simulé permettent d'observer sur la sortie du dispositif de simulation, si la défaillance ou le bon fonctionnement d'un ou plusieurs composants du système, provoque la défaillance (panne) ou le bon fonctionnement (réparation) de ce système. Le générateur de combinaison précité ne permet que la simulation d'événements (défaillance ou bon fonctionnement de composants d'un système) survenant simultanément, pour des études dans lesquelles l'ordre d'arrivée des événements n'intervient pas. Ce générateur qui présente un progrès évident par rapport aux systèmes de simulation utilisant des ordinateurs de puissance (de type Cray I. par exemple) ne permet toutefois pas de simuler des événements (défaillance ou bon fonctionnement des composants d'un système) survenant successivement ou en séquences. Or il apparaît souvent nécessaire, dans une étude de fiabilité d'un système, de faire intervenir des séquences de défaillance ou de bon fonctionnement dans lesquelles l'ordre d'arrivée des événements présente une grande importance pour l'étude de fiabilité. Les techniques de simulation (arbre de défaillance) qui étaient utilisées avec le générateur précité, ne peuvent alors pas être mises en oeuvre. Ces techniques connues nécessitent la construction d'un diagramme de Markov, en général très complexe, qui, pour un système comportant de nombreux composants, est impossible à concevoir.

Plus récemment encore a été développé un générateur séquentiel de signaux logiques combinés; ce générateur est décrit dans la demande de brevet n°. . . . déposée le même jour que la présente demande, au nom du même demandeur. Il permet notamment de fournir des signaux combinés de simulation, survenant en séquences.

Le dispositif de simulation de l'invention permet, en liaison avec un générateur séquentiel de ce type, de simuler la défaillance ou le bon fonctionnement d'un système dans lequel les défaillances ou bon fonctionnement des composants, surviennent séquentiellement. Ce dispositif ne présente pas les limitations de dispositifs de simulation connues (qui ne permettent que la simulation de systèmes comprenant 20 composants au maximum), puis qu'il permet de simuler des systèmes comprenant jusqu'à 80 composants. Il permet de plus, dans certaines conditions qui seront décrites plus loin, de déclencher une alarme, ou d'indiquer qu'une séquence de signaux de simulation appliqués sur les entrées du dispositif doit être invalidée, lorsque cette séquence ne correspond pas à une séquence souhaitée.

L'invention a pour objet un dispositif de simulation du fonctionnement d'un système constitué par une pluralité de composants $(C_i)$ interconnectés, pour simuler des évènements de fonctionnement des composants du système et pour fournir sur une sortie du système un état de fonctionnement de ce système, comprenant:

—un ensemble logique de moyens $(M_i)$ de simulation disposant chacun d'au moins une sortie $(S_{ij})$ et d'au moins une entrée $(E_{ik})$ de simulation, chaque moyen $(M_i)$ étant un circuit logique représentant le composant $(C_i)$ à simuler, l'évènement de fonctionnement de chaque composant étant une réparation ou une défaillance du composant $(C_i)$ et étant représenté par un signal fourni sur au moins une sortie $(S_{ij})$ du moyen $(M_{ij})$, ce signal ayant un premier ou un second état logique correspondant respectivement à la réparation ou à la défaillance du composant $(C_i)$ correspondant, chaque entrée $(E_{ik})$ de simulation recevant un signal logique de simulation ayant un premier ou deuxième état correspondant à l'évènement simulé et provoquant ou non le changement d'état du signal sur la sortie $(S_{ij})$ correspondante du circuit $(M_i)$, les défaillances ou les réparations apparaissant de façon combinée en séquences, pour l'ensemble des moyens $(M_i)$,

—des moyens (I) pour interconnecter les moyens de simulation $(M_i)$ selon une logique représentative de l'interconnexion des composants $(C_i)$ dans le système logique simulé, ces moyens d'interconnexion (I) ayant une sortie (S) fournissant un signal dont l'état logique est représentatif de la réparation ou de la défaillance du système simulé, caractérisé en ce que les moyens de simulation $(M_i)$ comprennent chacun une porte ET (10) de simulation à deux entrées, l'une des entrées de cette porte ET (10) étant reliée à la sortie d'un inverseur (11) de simulation, dont une entrée $(E_{11})$ peut recevoir le signal de simulation dont l'état logique correspond à la défaillance du composant $(C_i)$ correspondant, une porte OU (12) de simulation à deux entrées, l'une des entrées $(E_{12})$ de cette porte OU pouvant recevoir un signal de simulation dont l'état logique correspond à la réparation du composant $(C_i)$ correspondant, l'autre entrée de cette porte OU de simulation étant reliée à une sortie de la porte ET (10) de simulation, un multiplexeur (13) dont une entrée est reliée à une sortie de la porte OU (12) de simulation, deux autres entrées du multiplexeur recevant respectivement un signal (INIT) d'initialisation ainsi qu'un signal dont le niveau logique correspond à la défaillance ou à la réparation du composant correspondant à l'initialisation, une bascule (14) de type (D), dont l'entrée (D) est reliée à une sortie du multiplexeur (13) et dont une entrée d'horloge (CK) reçoit des impulsions d'horloge (CKS), la sortie (Q) de cette bascule étant reliée à l'autre entrée de la porte ET (10) de simulation, cette sortie constituant la sortie $(S_{ij})$ du moyen de simulation $(M_i)$ considéré.

Selon une autre caractéristique, le dispositif comprend des moyens d'invalidation V reliés à l'ensemble des moyens $M_i$ de simulation, ces moyens d'invalidation fournissant un signal INVALCOMB pour invalider toute séquence de signaux appliqués sur les entrées $E_{ik}$, lorsque la configuration de la séquence de signaux logiques appliqués sur ces entrées, ne correspond pas à la configuration souhaitée.

Selon une autre caractéristique, les moyens d'invalidation V sont aussi reliés aux moyens d'interconnexion I.

Selon une autre caractéristique, les moyens d'invalidation V comprennent pour chaque moyen de simulation $M_i$ un circuit d'invalidation comprenant une première porte ET à deux entrées, dont une entrée $E_{ik}$ peut recevoir le signal de simulation dont l'état correspond à la défaillance du composant $C_i$ correspondant, un inverseur dont une entrée est reliée à la sortie Q de la bascule D correspondante et dont la sortie est reliée à l'autre entrée de la première porte ET, une deuxième porte ET dont une entrée peut recevoir le signal de simulation dont l'état correspond au bon fonctionnement du composant $C_i$ correspondant, l'autre entrée de cette deuxième porte ET étant reliée à la sortie Q de la bascule D correspondante, une porte OU de sortie à deux entrées reliées respectivement aux sorties des première et deuxième portes ET, les moyens d'invalidation comprenant en outre une porte OU d'invalidation ayant des entrées respectivement reliées aux sorties des portes OU de sortie des circuits d'invalidation, une sortie de la porte OU d'invalidation fournissant éventuellement ledit signal INVALCOMB d'invalidation.

Les caractéristiques et avantages de l'invention ressortiront mieux de la description qui va suivre, donnée en référence aux dessins annexés dans lesquels:

—la figure 1 représente schématiquement un exemple de système à trois composants, qu'il est possible de simuler grâce au dispositif de l'invention,

—la figure 2 représente schématiquement, de manière plus détaillée, le dispositif de l'invention appliqué à la simulation du système de la figure 1,

—la figure 3 représente schématiquement un autre mode de réalisation du dispositif de l'invention.

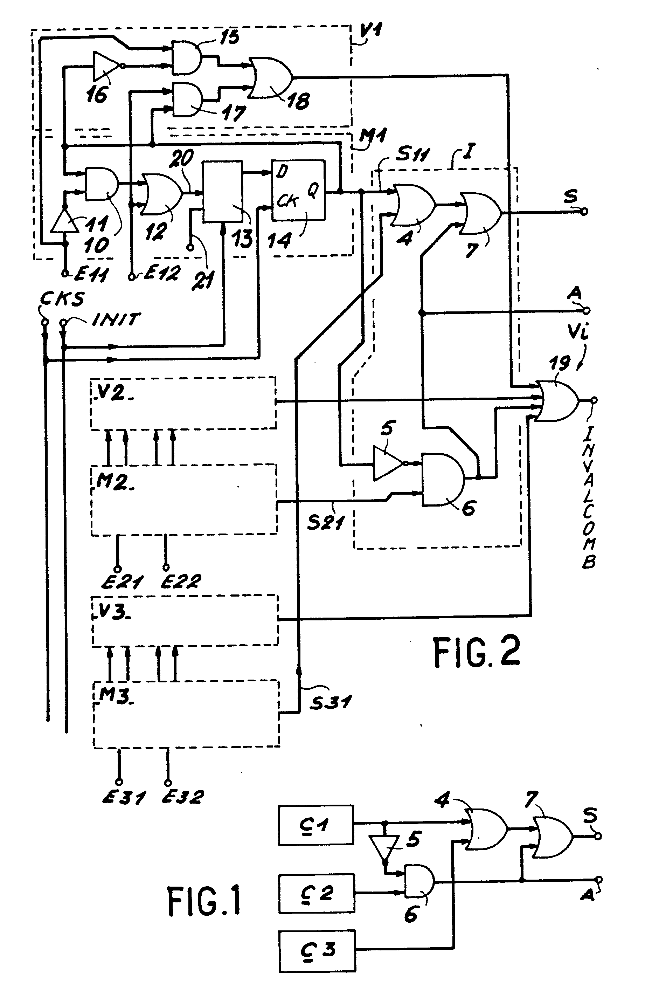

La figure 1 représente schématiquement un système à trois composants $C_1$, $C_2$, $C_3$ qu'il est possible de simuler grâce au dispositif de l'invention. On suppose que dans ce système, le composant $C_2$ est uniquement constitué par un ensemble superviseur du fonctionnement du composant $C_1$. Ce superviseur est capable de fournir un signal d'alarme de niveau logique 1, par exemple sur une sortie A, lorsque le composant $C_1$ est un état de défaillance. On suppose aussi que les composants $C_1$ et $C_3$ sont interconnectés à l'aide d'une pourte OU 4, qui fournit sur sa sortie, un signal logique de niveau 1 lorsque le composant $C_1$ ou le composant $C_3$ sont en état de bon fonctionnement.

Dans cet exemple, un signal d'alarme est fourni sur la sortie A du superviseur $C_2$, si le composant $C_1$ est mis en état de défaillance (signal de sortie présentant l'état logique 0), et que le superviseur n'est pas lui-même en état de défaillance. Par contre, si le superviseur $C_2$ qui supervise le fonctionnement du composant $C_1$ est mis en état de défaillance avant le composant $C_1$, sans que le composant $C_3$ soit lui-même défaillant, aucune alarme n'est générée, alors que le composant $C_1$ peut être en défaillance et que celle-ci n'est pas perçue puisque le superviseur $C_2$ est lui-même défaillant. Pour représenter ce fonctionnement il suffit d'utiliser des moyens d'interconnexion des composants $C_1$, $C_2$, $C_3$; ces moyens d'intercon-nexion comprennent un inverseur 5, une porte ET 6 et une porte OU 7. L'entrée de l'inverseur 5 est reliée à la sortie du composant $C_1$; la sortie de cet inverseur est reliée à l'une des entrées de la porte ET 6; l'autre entrée de la porte 6 est reliée à la sortie du composant superviseur $C_2$. La sortie de la porte ET 6 fournit un signal d'alarme en cas de panne du composant $C_1$ et elle est reliée à une entrée de la porte OU 7; une autre entrée de la porte 7 est reliée à une sortie de la porte OU 4. La sortie S de la porte OU 7 constitue la sortie S mentionnée plus haut; cette sortie fournit un signal de niveau logique 0 lorsque les compo-sants $C_1$ et $C_3$ sont simultanément en état de défaillance et qu'il n'y a pas d'alarme simulée en sortie de ET 6. Cette sortie S fournit un signal de niveau logique 1 lorsque les composants $C_1$ ou $C_3$ sont en bon fonctionnement. Grâce à l'inverseur 5 et à la porte ET 6, un signal d'alarme de niveau logique 1 est fourni sur la sortie A, lorsque le composant $C_1$ est mis en état de défaillance avant que le composant superviseur $C_2$ qui est chargé de surveiller $C_1$, soit lui-même en état de défaillance.

La figure 2 représente schématiquement un dispositif de simulation, conforme à l'invention, permettant de simuler les composants $C_1$, $C_2$, $C_3$ du système représenté en exemple sur la figure 1. Ce dispositif inclut, comme on le verra plus loin en détail, la porte OU 7 dont la sortie S fournit un signal dont l'état logique est représentatif de l'état de bon fonctionnement ou de défaillance du système simulé, un circuit permettant d'interconnecter les composants du système, ainsi que des moyens, qui seront aussi décrits plus loin en détail et qui permettent d'invalider certaines séquences de signaux logiques combinés, appliqués sur les entrées du dispositif.

Le dispositif de simulation représenté sur cette figure permet de simuler la défaillance ou le bon fonctionnement d'un système comprenant une pluralité de composants $C_i$ interconnectés, ces composants étant soumis à des événements tels que des défaillances ou des réparations (ou bons fonctionnements), apparaissant de façon combinée et en séquences. Le dispositif de l'invention comprend un ensemble de moyens $M_i$ de simulation, disposant chacun d'au moins une sortie $S_{ij}$, et d'au moins une entrée $E_{ik}$ de simulation. Chaque moyen $M_i$ est un ensemble logique représentant un composant $C_i$ du système à simuler. Dans son application au système de la figure 1, le dispositif de l'invention comprend les moyens de simulation $M_1$, $M_2$, $M_3$; les sorties $S_{ij}$ de ces moyens sont respectivement représentées $S_{11}$, $S_{21}$, $S_{31}$. Les entrées $E_{ik}$ de simulation de chaque composant sont respectivement représentées, pour les moyens de simulation $M_1$, $M_2$, $M_3$ en $E_{11}$ et $E_{12}$, $E_{21}$ et $E_{22}$, $E_{31}$ et $E_{32}$. L'état de défaillance ou de bon fonctionnement de chaque composant $C_i$ est représenté par un signal fourni sur la sortie $S_{ij}$ du moyen $M_i$ correspondant. Ce signal présente un premier état logique ou un second état logique qui correspondent respectivement au bon fonctionnement (réparation) ou à la défaillance (panne) du composant $C_i$ considéré. C'est ainsi par exemple que la défaillance du composant $C_1$ est représentée, sur la sortie $S_{11}$, par un signal présentant un second état logique (état logique 0 par exemple); le bon fonctionnement (ou la réparation) de ce composant est représenté sur la sortie $S_{11}$ par un signal présentant un premier état logique (état logique 1 par exemple). Les entrées $E_{ik}$ de simulation de chaque moyen $M_i$ reçoivent un signal logique de simulation, ayant un état logique correspondant à l'événement simulé, et provoquant ou non le changement d'état du signal sur la sortie $S_{ij}$ correspondante du circuit $M_i$. C'est ainsi par exemple, que la simulation du bon fonctionnement du composant $C_1$ est obtenue en appliquant un signal de simulation de niveau logique 1 sur l'entrée $E_{12}$ du moyen de simulation $M_1$ (l'entrée $E_{11}$ étant au niveau logique 0). De la même manière, la défaillance du composant $C_1$ est obtenue en appliquant un signal de niveau logique 1 sur l'entrée $E_{11}$ du moyen de simulation $M_1$ (l'entrée $E_{12}$ étant au niveau logique 0). Il en est de même pour les signaux de simulation appliqués sur les entrées $E_{22}$ et $E_{21}$ du moyen de simulation $M_2$, correspondant au composant $C_2$ et pour les signaux appliqués sur les entrées $E_{32}$ et $E_{31}$ du moyen de simulation $M_3$, correspondant au composant $C_3$.

Les signaux de simulation appliqués sur les entrées $E_{ik}$ sont fournis par exemple par un générateur séquentiel tel que décrit dans la demande de brevet n°. ... déposée le ... au nom du même demandeur.

Le dispositif comprend aussi de moyens I qui permettent d'interconnecter les moyens de simulation $M_i$ ($M_1$, $M_2$, $M_3$), selon une logique représentative de l'interconnexion des composants $C_i$ du système logique simulé. C'est ainsi que dans l'exemple représenté sur la figure, correspondant à la simulation du système de la figure 1, les moyens d'interconnexion I comprennent deux portes OU 4, 7, une porte ET 6 et un inverseur 5; ces portes correspondent à celles de la figure 1. Les entrées de la porte OU 4 sont respectivement reliées à la sortie $S_{11}$ du moyen de simulation $M_1$ du composant $C_1$ et à la sortie $S_{31}$ du moyen de simulation $M_3$ du composant $C_3$. La sortie de la porte OU 4 est reliée à une entrée de la porte OU 7. Une autre entrée de la porte OU 7 est reliée à la sortie de la porte ET 6. Une entrée de la porte ET 6 est reliée à la sortie $S_{21}$ du moyen de simulation $M_2$ du composant $C_2$. Une autre entrée de cette porte est reliée à la sortie de l'inverseur 5; l'entrée de cet inverseur et reliée à la sortie $S_{11}$ du moyen de simulation $M_1$ du composant $C_1$. La sortie S des moyens d'interconnexion I fournit comme on le verra plus loin en détail, un signal dont l'état logique est représentatif du bon fonctionnement ou de la défaillance du système simulé par les moyens $M_1$, $M_2$, $M_3$.

Le dispositif de simulation comprend aussi des moyens $V_i$ d'invalidation reliés à l'ensemble des moyens de simulation $M_i$. Ces moyens fournissent éventuellement sur une sortie INVALCOMB un signal de niveau logique 1 permettant d'invalider toute séquence de signaux appliqués sur les entrées $E_{ik}$, lorsque la configuration de cette séquence de signaux logiques ne correspond pas à une configuration souhaitée, comme on le verra plus loin en détail.

Les moyens de simulation $M_2$, $M_3$ sont identiques; seul le moyen de simulation $M_1$ a été représenté de manière détaillée sur la figure. Chacun des moyens de simulation $M_i$ comprend une porte ET 10 de simulation, à deux entrées. L'une des entrées de cette porte est reliée à la sortie d'un inverseur 11 de simulation; l'entrée de cet inverseur constitue l'entrée $E_{11}$ du moyen de simulation $M_1$ et peut recevoir le signal de simulation dont l'état logique (1 dans l'exemple considéré) correspond à la défaillance du composant $C_1$. Le moyen de simulation $M_1$ comprend aussi une porte OU 12 de simulation, à deux entrées; l'une des entrées de cette porte OU correspond à l'entrée de simulation $E_{12}$ du moyen $M_1$. Cette entrée peut recevoir un signal de simulation dont l'état logique (1 dans l'exemple considéré), correspond au bon fonctionnement du composant $C_1$. L'autre entrée de la porte OU 12 est reliée à la sortie de la porte ET 10 de simulation. Le moyen $M_1$ comprend aussi un multiplexeur 13 dont une entrée est reliée à la sortie de la porte OU 12 de simulation et dont une autre entrée reçoit, à l'initialisation, un signal INIT de niveau logique 1, comme on le verra plus loin en détail. Enfin, le moyen de simulation $M_1$ comprend une bascule 14 de type D, dont l'entrée D est reliée à une sortie du multiplexeur 13, et dont l'entrée d'horloge CK reçoit des impulsions d'horloge CKS. La sortie Q de la bascule 14 est reliée à l'autre entrée de la porte ET 10 de simulation; la sortie Q de la bascule 14 constitue la sortie $S_{11}$ du moyen de simulation $M_1$ consi-

déré. Les autres moyens de simulation $M_2$, $M_3$ ne sont pas décrits en détail et ils sont constitués de la même manière que le moyen de simulation $M_1$.

Les moyens d'invalidation comprennent, pour chaque moyen de simulation $M_i$, un circuit d'invalidation $V_i$. C'est ainsi que dans l'exemple d'application considéré, les moyens d'invalidation comprennent des circuits d'invalidation $V_1$, $V_2$, $V_3$ reliés respectivement aux moyens de simulation $M_1$, $M_2$, $M_3$. Les circuits d'invalidation $V_1$, $V_2$, $V_3$ sont identiques et seul le circuit $V_1$ sera décrit en détail: ce circuit comprend une première porte ET 15 à deux entrées, dont une entrée peut recevoir le signal de simulation appliqué sur l'entrée $E_{11}$ du moyen $M_1$ l'état logique 1 de ce signal correspondant à la simulation de la défaillance du composant $C_1$. Ce circuit de validation $V_1$ comprend aussi un inverseur 16 ayant une entrée reliée à la sortie Q de la bascule D 14 correspondante. La sortie de cet inverseur est reliée à l'autre entrée de la première porte ET 15. Le circuit $V_1$ comprend aussi une deuxième porte ET 17 dont une entrée est reliée à l'entrée $E_{12}$ du moyen de simulation $M_1$, pour recevoir le signal de simulation dont l'état logique 1 correspond à la réparation du composant $C_1$. L'autre entrée de la deuxième porte ET 17 est reliée à la sortie Q de la bascule D14. Enfin, le circuit d'invalidation $V_1$ comprend une porte OU 18 de sortie. Cette porte présente deux entrées qui sont respectivement reliées aux sorties des première et deuxième portes ET 15, 17. Les moyens d'invalidation comprennent aussi une porte OU 19 d'invalidation, dont les entrées sont respectivement reliées aux sorties des portes OU 18 des circuits d'invalidation $V_1$, $V_2$, $V_3$. Une sortie de la porte OU 19 d'invalidation fournit, dans certaines conditions qui seront décrites plus loin en détail, un signal INVALCOMB de niveau logique 1, permettant d'invalider une séquence de signaux de simulation appliqués sur les entrées des moyens de simulation $M_1$, $M_2$, $M_3$. Une entrée de la porte OU 19 est aussi reliée à la sortie de la porte ET 6 des moyens d'interconnexion I.

Les moyens de simulation $M_1$, $M_2$, $M_3$ fonctionnent de manière semblable; il en est de même pour le fonctionnement des circuits de simulation $V_1$, $V_2$, $V_3$. Seuls les fonctionnements des moyens de simulation $M_1$ et du circuit d'invalidation $V_1$ vont maintenant être décrits en détail.

Au début d'une séquence de signaux logiques combinés (de niveau logique 1 et 0 selon la simulation à effectuer) appliqués sur les entrées $E_{11}$, $E_{12}$, . . ., $E_{32}$ des moyens de simulation $M_1$, $M_2$, $M_3$ du dispositif de simulation du système de la figure 1, un signal INIT d'initialisation, de niveau logique 1, est appliqué par exemple par le générateur séquentiel mentionné plus haut, sur l'entrée correspondante du dispositif de l'invention. Ce signal est fourni aux multiplexeurs (tels que le multiplexeur 13) des moyens $M_1$, $M_2$, $M_3$ de simulation. Ce signal de niveau logique 1 se retrouve sur les sorties correspondantes des multiplexeurs et il est appliqué sur les entrées D des bascules (telles que la bascule 14) des moyens

$M_1$, $M_2$, $M_3$. Toutes ces bascules de type D mémorisent alors le niveau logique 1 à la première impulsion d'horloge CKS, fournie en même temps que le signal INIT, sur les entrées CK des bascules. Les sorties Q des bascules 14 des moyens de simulation $M_1$, $M_2$, $M_3$ fournissent alors respectivement des signaux du niveau logique 1. Un signal de niveau logique 1 est alors fourni à l'initialisation, sur la sortie S des moyens d'interconnexion I, grâce aux portes OU 4, 7. En fait, chacun des multiplexeurs 13 comprend deux entrées: une entrée 20 reliée à la sortie de la porte OU 12, et une entrée 21 qui reçoit un signal dont le niveau logique correspond au niveau logique d'initialisation du composant, qui est en général le niveau logique 1. Le signal INIT provenant de la porte OU 12 à l'initialisation du composant sert à sélectionner le niveau logique du signal présent sur l'entrée 21. Le niveau logique sur l'entrée 21 peut être 0, si à l'initialisation on décide que le composant correspondant au multiplexeur considéré est défaillant. L'initialisation du dispositif de simulation étant effectuée, on va alors appliquer sur les entrées de simulation des moyens $M_1$, $M_2$, $M_3$, des séquences de signaux logiques combinés, de niveaux 1 et 0 dépendant des simulations effectuées (défaillance de certains composants et bon fonctionnement d'autres composants). Si à un instant $t_i$ un signal de simulation de niveau logique 1 est appliqué par exemple sur l'entrée $E_{11}$ des moyens $M_1$, pour simuler la défaillance du composant correspondant $C_1$, en même temps qu'une impulsion d'horloge CKS est appoiquée à la bascule 14, cette bascule 14 fournit sur la sortie $S_{11}$, un signal de niveau logique 0, représentant la défaillance du composant $C_1$. On suppose bien entendu dans ce cas que le signal appliqué à cet instant sur l'entrée $E_{12}$ du moyen de simulation $M_1$, est un signal de niveau logique 0. On peut également supposer que pour cette séquence, à cet instant $t_i$, des signaux de niveau logique 0 sont appliqués sur les entrées $E_{22}$ et $E_{32}$ et que des signaux de niveau logique 0 sont aussi appliqués sur les entrées $E_{21}$ et $E_{31}$ des moyens de simulation $M_2$, $M_3$, pour conserver le bon fonctionnement des composants $C_2$, $C_3$ correspondants. Il en résulte que pour cette séquence à cet instant $t_i$, la sortie $S_{11}$ du moyen $M_1$ est au niveau logique 0 tandis que les sorties des moyens $M_2$, $M_3$ sont au niveau logique 1. La sortie S des moyens d'interconnexion I est donc elle-même au niveau logique 1. Ce niveau logique indique que le système de la figure 1 est en état de bon fonctionnement lorsque seul le composant $C_1$ est en état de défaillance.

Si à l'instant $t_{i+1}$ par exemple la séquence de signaux combinés de simulation appliqués sur les entrées des moyens $M_1$, $M_2$, $M_3$ est telle que les sorties $S_{11}$ et $S_{31}$ sont au niveau logique 0, (indiquant la défaillance des composants $C_1$ et $C_3$ correspondants), la sortie S de la porte OU 4 des moyens d'interconnexion I est elle-même au niveau logique 0 qui indique la défaillance totale du système simulé. (Le composant $C_2$ est un superviseur dans l'exemple de l'application considéré). Dans cet exemple, le superviseur $C_2$ n'étant pas en panne, dès l'instant $t_i$, la sortie S de la porte OU 7 est au niveau logique 1 (car $S_{21}=1$, et $S_{11}=0$) et un signal d'alarme de niveau logique 1 est fourni sur la sortie A.

Si la sortie $S_{11}$ est au niveau logique 0 pour indiquer une défaillance du composant $C_1$, alors que la sortie $S_{21}$ du composant $C_2$ (un superviseur dans l'exemple d'application considéré) montre un état de bon fonctionnement (niveau logique 1 sur la sortie $S_{21}$) une alarme est déclenchée sur la sortie A de la porte ET 6. Le signal de niveau logique 1 qui est alors présent sur la sortie de la porte ET 6 est appliqué sur l'entrée de la porte OU 7. Il en résulte que le signal de niveau logique 1 sur la sortie de la porte ET 6 vient inhiber le passage au niveau logique 0 du signal sur la sortie S de la porte OU 7. La sortie de la porte ET 6 est également reliée à la porte OU 19 et un signal INVALCOMB de niveau logique 1 apparaît sur la sortie de cette porte OU 19. Ce signal indique que la séquence de signaux logiques présente sur les entrées de simulation des moyens $M_1$, $M_2$, $M_3$ doit être invalidée puisque cette séquence qui aurait dû produire sur la sortie S un signal de niveau logique 0 indiquant la défaillance du système produit en fait un signal de niveau logique 1 indiquant son bon fonctionnement.

Les circuits d'invalidation $V_1$, $V_2$, $V_3$ dont les sorties sont reliées aux entrées de la porte OU 19 de sortie, permettent aussi d'invalider toute séquence, par un signal INVALCOMB de niveau logique 1, sur la sortie de la porte OU 19, dans les conditions suivantes: lorsqu'un signal de défaillance, de niveau logique 1, est appliqué à un instant $t_i$ sur une entrée de défaillance (telle que $E_{11}$ par exemple) alors que la sortie du composant correspondant est déjà au niveau logique 0 à l'instant $t_i$, ou lorsqu'un signal de niveau logique 1 est appliqué à un instant $t_i$ sur une entrée de réparation ($E_{12}$ par exemple), alors que la sortie correspondante est déjà au niveau logique 1 à l'instant $t_i$. Dans ces deux cas en effet, le signal INVALCOMB sur la sortie de la porte OU 19 passe au niveau logique 1 pour indiquer que la séquence correspondante ne doit pas être prise en considération, puisque l'événement simulé n'a pas d'action sur le composant.

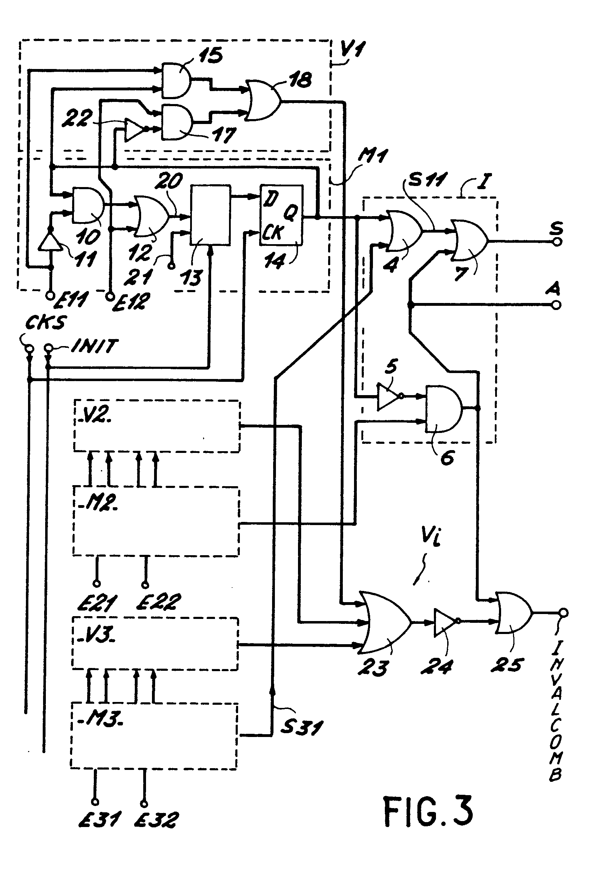

La figure 3 représente schématiquement un autre mode de réalisation du dispositif de l'invention. Les mêmes éléments portent les mêmes références sur cette figure et sur la figure 2. Les différences entre le mode de réalisation de la figure 3 et le mode de réalisation de la figure 2 portent essentiellement sur les moyens d'invalidation $V_i$ reliés respectivement aux moyens de simulation $M_i$, ainsi que sur le circuit de sortie de ces moyens d'invalidation, qui fournit, sur une sortie INVALCOMB, un signal d'invalidation de niveau logique 1, dans des conditions qui seront décrites plus loin en détail.

Dans le mode de réalisation de la figure 3, les moyens d'invalidation $V_i$, tels que le moyen $V_1$, ne comportent plus un inverseur sur l'une des entrées de la porte ET 15 mais comprennent un inverseur 22 qui relie l'une des entrées de la porte ET 17 à la sortie de la bascule 14. Les autres éléments de connexion de ces moyens d'invalidation $V_1$ sont inchangés.

Dans ce mode de réalisation, le circuit de sortie des moyens d'invalidation, capable de fournir sur une sortie invalcomb, un signal d'invalidation dans certaines conditions, n'est plus constitué par une porte OU unique comme dans le mode de réalisation précédent, mais par une porte OU 23, un inverseur 24 et une porte OU 25. Les entrées de la porte OU 23 sont respectivement reliées aux sorties des moyens d'invalidation $V_1$, $V_2$, $V_3$. La sortie de la porte OU 23 est reliée à l'entrée de l'inverseur 24. Les deux entrées de la porte ou 25 sont respectivement reliées à la sortie de l'inverseur 24 et à la sortie de la porte ET 6 des moyens d'interconnexion I.

Dans cet autre mode de réalisation, le générateur séquentiel applique des signaux représentatifs de panne ou de réparation sur les entrées $E_{ik}$, un par un à des instants différents. Si à un instant donné, un signal de niveau logique 1 par exemple, représentatif d'une défaillance ou panne (qui est donc seul à cet instant), arrive sur une entrée de simulation d'un composant déjà en panne, aucun signal de niveau logique 1 n'est transmis vers la porte OU 23. Il en résulte que la sortie de cette porte OU 23 est au niveau logique 0 et que la sortie de l'inverseur 24 est au niveau logique 1. Un signal d'invalidation, de niveau logique 1, est donc fourni sur la sortie INVALCOMB de la porte OU 25.

## Revendications

1. Dispositif de simulation du fonctionnement d'un système constitué par une pluralité de composants ($C_i$) interconnectés, pour simuler des évènements de fonctionnement des composants du système et pour fournir sur une sortie du système un état de fonctionnement de ce système, comprenant:

—un ensemble logique de moyens ($M_i$) de simulation disposant chacun d'au moins une sortie ($S_{ij}$) et d'au moins une entrée ($E_{ik}$) de simulation, chaque moyen ($M_i$) étant un circuit logique représentant le composant ($C_i$) à simuler, l'évènement de fonctionnement de chaque composant étant une réparation ou une défaillance du composant ($C_i$) et étant représenté par un signal fourni sur au moins une sortie ($S_{ij}$) du moyen ($M_{ij}$), ce signal ayant un premier ou un second état logique correspondant respectivement à la réparation ou à la défaillance du composant ($C_i$) correspondant, chaque entrée ($E_{ik}$) de simulation recevant un signal logique de simulation ayant un premier ou un deuxième état correspondant à l'évènement simulé et provoquant ou non le changement d'état du signal sur la sortie ($S_{ij}$) correspondante du circuit ($M_i$), les défaillances ou les réparations apparaissant de façon combinée en séquences, pour l'ensemble des moyens ($M_i$),

—des moyens (I) pour interconnecter les moyens de simulation ($M_i$) selon une logique

représentative de l'interconnexion des composants $(C_i)$ dans le système logique simulé, ces moyens d'interconnexion (I) ayant une sortie (S) fournissant un signal dont l'état logique est représentatif de la réparation ou de la défaillance du système simulé, caractérisé en ce que les moyens de simulation $(M_i)$ comprennent chacun une porte ET (10) de simulation à deux entrées, l'une des entrées de cette porte ET (10) étant reliée à la sortie d'un inverseur (11) de simulation, dont une entrée $(E_{11})$ peut recevoir le signal de simulation dont l'état logique correspond à la défaillance du composant $(C_i)$ correspondant, une porte OU (12) de simulation à deux entrées, l'une des entrées $(E_{12})$ de cette porte OU pouvant recevoir un signal de simulation dont l'état logique correspond à la réparation du composant $(C_i)$ correspondant, l'autre entrée de cette porte OU de simulation étant reliée à une sortie de la porte ET (10) de simulation, un multiplexeur (13) dont une entrée est reliée à une sortie de la porte OU (12) de simulation, deux autres entrées du multiplexeur recevant respectivement un signal (INIT) d'initialisation ainsi qu'un signal dont le niveau logique correspond à la défaillance ou à la réparation du composant correspondant à l'intitialisation, une bascule (14) de type (D), dont l'entrée (D) est reliée à une sortie du multiplexeur (13) et dont une entrée d'horloge (CK) reçoit des impulsions d'horloge (CKS), la sortie (Q) de cette bascule étant reliée à l'autre entrée de la porte ET (10) de simulation, cette sortie constituant la sortie $(S_{ij})$ du moyen de simulation $(M_i)$ considéré.

2. Dispositif de simulation selon la revendication 1, caractérisé en ce qu'il comprend des moyens d'invalidation reliés à l'ensemble des moyens $(M_i)$ de simulation, ces moyens d'invalidation fournissant un signal (INVALCOMB) pour invalider toute séquence de signaux appliqués sur les entrées $(E_{ik})$ lorsque la configuration de la séquence de signaux logiques appliqués sur ces entrées ne correspond pas à une configuration souhaitée.

3. Dispositif de simulation selon la revendication 1, caractérisé en ce que les moyens d'invalidation (V) sont aussi reliés aux moyens d'interconnexion (I).

4. Dispositif selon la revendication 3, caractérisé en ce que les moyens d'invalidation comprennent pour chaque moyen de simulation $(M_i)$ un circuit d'invalidation $(V_1)$ comprenant une première porte ET (15) à deux entrées, dont une entrée $(E_{11})$ peut recevoir le signal de simulation dont l'état logique correspond à la défaillance du composant $(C_1)$ correspondant, un inverseur (16) dont une entrée est reliée à la sortie (Q) de la bascule D (14) correspondante et dont la sortie est reliée à l'autre entrée de la première porte ET (15), une deuxième porte ET (17) dont une entrée $(E_{12})$ peut recevoir le signal de simulation dont l'état logique correspond à la réparation du composant $(C_1)$ correspondant, l'autre entrée de cette deuxième porte ET (17) étant reliée à la sortie (Q) de la bascule D (14) correspondante, une porte OU (18) de sortie, à deux entrées reliées respectivement aux sorties des première et deuxième portes ET (15, 17), les moyens d'invalidation comprenant en outre au moins une porte OU (19) d'invalidation ayant des entrées respectivement reliées aux sorties des portes OU (18) de sortie des circuits d'invalidation $(V_1, V_2, V_3)$ et à une sortie de la porte OU (19) d'invalidation fournissant éventuellement ledit signal (INVALCOMB) d'invalidation.

5. Dispositif selon la revendication 3, caractérisé en ce que les moyens d'invalidation comprennent pour chaque moyen de simulation $(M_1)$ un circuit d'invalidation $(V_1)$ comprenant une première porte ET (15) à deux entrées, dont une entrée $(E_{11})$ peut recevoir le signal de simulation dont l'état logique correspond à la défaillance du composant $(C_1)$ correspondant, l'autre entrée de cette première porte ET (15) étant reliée à la sortie (Q) de la bascule D (14) correspondante, une deuxième porte ET (17) dont une entrée $(E_{12})$ peut recevoir le signal de simulation dont l'état logique correspond à la réparation du composant $(C_1)$ correspondant, un inverseur (22) dont une entrée est reliée à la sortie (Q) de la bascule D (14) correspondante et dont la sortie est reliée à l'autre entrée de la deuxième porte ET (15), une porte OU (18) de sortie, à deux entrées reliées respectivement aux sorties des première et deuxième portes ET (15, 17), les moyens d'invalidation comprenant en outre au moins une autre porte OU (23) ayant des entrées respectivement reliées aux sorties des portes OU (18) de sortie des circuits d'invalidation $(V_1, V_2, V_3)$, un inverseur de sortie (24) dont une entrée est reliée à une sortie de ladite autre porte OU (23), et une porte OU (25) d'invalidation dont une entrée est reliée à une sortie de l'inverseur et dont une autre entrée est reliée à une sortie des moyens d'interconnexion (I), une sortie de la porte OU (25) d'invalidation fournissant éventuellement ledit signal (INVALCOMB) d'invalidation.

**Patentansprüche**

1. Vorrichtung zur Funktionssimulation eines Systems, das aus einer Mehrzahl miteinander verbundener Bestandteile $(C_i)$ besteht, um Funktionsereignisse der Systembestandteile zu simulieren und auf einem Systemausgang einen Funktionszustand dieses Systems zu liefern, mit:

—einem logischen Ensemble von Simulationsvorrichtungen $(M_i)$, von denen jede über wenigstens einen Simulationsausgang $(S_{ij})$ und einen Simulationseingang $(E_{ij})$ verfügt, wobei jede Simulationsvorrichtung $(M_i)$ ein logischer Schaltkreis ist, der den zu simulierenden Bestandteil $(C_1)$ darstellt, wobei das Funktionsereignis jedes Bestandteils eine Reparatur oder ein Ausfall des Bestandteils $(C_i)$ ist und durch ein auf wenigstens einem Ausgang $(S_{ij})$ der Vorrichtung $(M_{ij})$ erzeugtes Signal dargestellt wird, wobei dieses Signal einen ersten und einen zweiten logischen Zustand besitzt, der jeweils der Reparatur oder dem Ausfall des entsprechenden Bestandteils $(C_i)$ entspricht, wobei jeder Simulationseingang $(E_{ij})$ ein

logisches Simulationssignal empfängt, das einen ersten oder zweiten logischen Zustand besitzt, der dem simulierten Ereignis entspricht und die Veränderung des Zustands des Signals am Ausgang $(S_{ij})$ des entsprechenden Schaltkreises $(M_i)$ bewirkt oder nicht, wobei die Ausfälle oder die Reparaturen für die Gesamtheit der Vorrichtungen $(M_i)$ in kombinierter Form in Folgen erscheinen,

—Vorrichtungen (I) zum Verbinden der Simulationsvorrichtungen $(M_i)$ nach einer repräsentativen Verbindungslogik für die Bestandteile $(C_i)$ in dem simulierten logischen System, wobei diese Verbindungsvorrichtungen (I) einen Ausgang (S) besitzen, der ein Signal liefert, dessen logischer Zustand die Reparatur oder den Ausfall des simulierten Systems darstellt, dadurch gekennzeichnet, daß die Simulationsvorrichtungen $(M_i)$ jeweils umfassen; ein Simulationsgatter UND (10) mit zwei Eingängen, wobei der eine der Eingänge dieses Gatters UND (10) mit dem Ausgang eines Simulationsinverters (11) verbunden ist, von dem ein Eingang $(E_{11})$ das Simulationssignal empfangen kann, dessen logischer Zustand dem Ausfall des Bestandteils $(C_i)$ entspricht; ein Simulationsgatter ODER (12) mit zwei Eingängen, wobei der eine der Eingänge $(E_{12})$ dieses Gatters ODER ein Simulationssignal empfangen kann, dessen logischer Zustand der Reparatur des entsprechenden Bestandteils (Ci) entspricht, wobei der andere Eingang dieses Simulationsgatters ODER mit einem Ausgang des Simulationsgatters UND (10) verbunden ist; eine Multiplexer (13), von dem ein Eingang mit einem Eingang des Simulationsgatters ODER (12) verbunden ist, während zwei weitere Eingänge des Multiplexers jeweils ein Initialisierungssignal (INIT) ebenso wie ein Signal empfangen, dessen logischer Zustand dem Ausfall oder der Reparatur des entsprechenden Bestandteils bei der Initialisierung entspricht; und ein D-Flip-Flop (14), dessen Eingang (D) mit einem Ausgang des Multiplexers (13) verbunden ist und von dem ein Takteingang (CK) Taktpulse (CKS) empfängt, wobei der Ausgang (Q) dieses Flip-Flops mit dem anderen Eingang des Simulationsgatters UND (10) verbunden ist, wobei dieser Ausgang den Ausgang $(S_{ij})$ der betrachteten Simulationsvorrichtung $(M_i)$ bildet.

2. Simulationsvorrichtung nach Anspruch 1, dadurch gekennzeichnet, daß sie Vorrichtungen zum Ungültigmachen umfaßt, die mit der Gesamtheit der Simulationsvorrichtung $(M_i)$ verbunden sind, wobei diese Vorrichtungen zum Ungültigmachen ein Signal (INVALCOMB) erzeugen, um jede an die Eingänge $(E_{ij})$ angelegt Signalsequenz ungültig zu machen, sobald die Konfiguration der an diese Eingänge angelegten logischen Signalsequenz nicht der gewünschten Konfiguration entspricht.

3. Simulationsvorrichtung nach Anspruch 2, dadurch gekennzeichnet, daß die Vorrichtungen (V) zum Ungültigmachen ebenfalls mit den Verbindungsvorrichtungen (I) verbunden sind.

4. Vorrichtung nach Anspruch 3, dadurch gekennzeichnet, daß die Vorrichtungen zum Ungültigmachen für jede Simulationsvorrichtung $(M_1)$ umfassen; einen Schaltkreis $(V_1)$ zum Ungültigmachen mit einem ersten Gatter UND (15) mit zwei Eingängen, von denen ein Eingang $(E_{11})$ das Simulationssignal empfangen kann, dessen logischer Zustand dem Ausfall des entsprechenden Bestandteils $(C_1)$ entspricht; einen Inverter (16), von dem ein Eingang mit dem Ausgang (Q) des entsprechenden D-Flip-Flops (14) verbunden ist und dessen Ausgang mit dem anderen Eingang des ersten Gatters UND (15) verbunden ist; ein zweites Gatter UND (17), von dem ein Eingang $(E_{12})$ das Simulationssignal empfangen kann, dessen logischer Zustand der Reparatur des entsprechenden Bestandteils $(C_1)$ entspricht, wobei der andere Eingang dieses zweiten Gatters UND (17) mit dem Ausgang (Q) des entsprechenden D-Flip-Flops (14) verbunden ist; ein Ausgangsgatter ODER (18) mit zwei Eingängen, die jeweils mit dem Ausgängen des ersten und zweiten Gatters UND (15, 17) verbunden sind, wobei die Vorrichtungen zum Ungültigmachen außerdem wenigstens ein Gatter ODER (19) zum Ungültigmachen mit Eingängen umfassen, die jeweils mit den Ausgängen der Ausgangsgatter ODER (18) des Schaltkreis $(V_1, V_2, V_3)$ zum Ungültigmachen und mit einem Ausgang des Gatters ODER (19) zum Ungültigmachen verbunden sind, das schließlich das Signal (INVALCOMB) zum Ungültigmachen liefert.

5. Vorrichtung nach Anspruch 3, dadurch gekennzeichnet, daß die Vorrichtungen zum Ungültigmachen für jede Simulationsvorrichtung $(M_1)$ umfassen: einen Schaltkreis $(V_1)$ zum Ungültigmachen mit einem ersten Gatter UND (15) mit zwei Eingängen, von denen ein Eingang $(E_{11})$ das Simulationssignal empfangen kann, dessen logischer Zustand dem Ausfall des entsprechenden Bestandteils $(C_1)$ entspricht, während der andere Eingang des ersten Gatters UND (15) mit dem Ausgang (Q) des entsprechenden D-Flip-Flops (14) verbunden ist; ein zweites Gatter UND (17), von dem ein Eingang $(E_{12})$ das Simulationssignal empfangen kann, dessen logischer Zustand der Reparatur des entsprechenden Bestandteils $(C_1)$ entspricht; einen Inverter (22), von dem ein Eingang mit dem Ausgang (Q) des entsprechenden D-Flip-Flops (14) verbunden ist und dessen Ausgang mit dem anderen Eingang des ersten Gatters UND (15) verbunden ist; ein Ausgangsgatter ODER (18) mit zwei Eingängen, die jeweils mit den Ausgängen des ersten und zweiten Gatters UND (15, 17) verbunden sind; wobei die Vorrichtungen zum Ungültigmachen außerdem aufweisen; wenigstens ein weiteres Gatter ODER (23) zum Ungültigmachen mit Eingängen die jeweils mit den Ausgängen der Ausgangsgatter ODER (18) der Schaltkreis $(V_1, V_2, V_3)$ zum Ungültigmachen verbunden sind; einen Ausgangsinverter (24), von dem ein Eingang mit dem Ausgangs des weiteren Gatters ODER (23) verbunden ist; und ein Gatter ODER (25) zum Ungültigmachen, von dem ein Eingang mit einem Ausgang des Inverters verbunden ist und von dem ein anderer Eingang mit einem Ausgang der Verbindungsvorrichtungen (I) verbunden ist, wobei ein Ausgang des Gatters ODER (25) zu Ungültigmachen schließlich das Signal (INVALCOMB) zum Ungültigmachen liefert.

## Claims

1. Apparatus for simulating the operation of a system consistuted by a plurality of interconnected components ($C_i$), for simulating operating events of the components of the system and for supplying on an output of the system an operating state thereof, comprising a logic array of simulated means ($M_i$), each having at least one simulation output ($S_{ij}$) and at least one simulation input ($E_{ik}$), each means ($M_i$) being a logic circuit representing the component ($C_i$) to be simulated, the operating event of each component being a repair or a failure of the component ($C_i$) and being represented by a signal supplied on at least one output ($S_{ij}$) of the means ($M_{ij}$), said signal having a first or a second logic state respectively corresponding to the repair or failure of the corresponding component ($C_i$), each simulation input ($E_{ik}$) receiving a logic simulation signal having a first or a second state corresponding to the simulated event and causing or not the change of state of the signal on the corresponding output ($S_{ij}$) of the circuit ($M_i$), the failures or repairs appearing in combined manner in sequences for all the means ($M_i$); means (I) for interconnecting the simulation means ($M_i$) according to a logic representing the interconnection of the component ($C_i$) in the simulated logic system, said interconnection means (I) having an output (S) supplying a signal, whose logic state represents the repair or failure of the simulated system, characterized in that the simulation means ($M_i$) each have a simulation AND gate (10) with two inputs, one of the inputs of said AND gate 10 being connected to the output of a simulation inverter (11), whereof an input ($E_{11}$) can receive the simulation signal, whose logic state corresponds to the failure of the corresponding component ($C_i$), a simulation OR gate (12) with two inputs, one of the inputs ($E_{12}$) of said OR gate being able to receive a simulation signal, whose logic state corresponds to the repair of the corresponding component ($C_i$), the other input of said simulation OR gate being connected to an output of the simulation AND gate (10), a multiplexer (13), whereof one input is connected to an output of the simulation OR gate (12), two other inputs of the multiplexer respectively receiving an initialization signal in it, as well as a signal whose logic level corresponds to the failure or repair of the component corresponding to the initialization, a D-type flop-flop (14), whose input (D) is connected to an output of the multiplexer (13) and whose clock input (CK) receives clock pulses (CKS), the output (Q) of said flip-flop being connected to the other input of the simulation AND gate 10, said output constituting the output ($S_{ij}$) of the simulation means ($M_i$) considered.

2. Simulation apparatus according to claim 1, characterized in that it comprises invalidation means connected to the group of simulation means ($M_i$), said invalidation means supplying a signal (INVALCOMB) for invalidating any sequence of signals applied to the inputs ($E_{ik}$), when the configuration of the sequence of logic signals applied to these inputs does not correspond to a desired configuration.

3. Simulation apparatus according to claim 2, characterized in that the invalidation means (V) are also connected to interconnection means (I).

4. Apparatus according to claim 3, characterized in that the invalidation means comprise for each simulation means ($M_i$), an invalidation circuit ($V_1$) having a first AND gate (15) with two inputs, whereof one input ($E_{11}$) can receive the simulation signal, whose logic state corresponds to the failure of the corresponding component ($C_1$), an inverter (16) whereof an input is connected to the output (Q) of the corresponding D flip-flop (14) and whose output is connected to the other input of the first AND gate (15), a second AND gate (17) whereof an input ($E_{12}$) can receive the simulation signal, whose logic state corresponds to the repair of the corresponding component ($C_1$), the other input of said second AND gate (17) being connected to the output (Q) of the corresponding D flip-flop (14), an output OR gate (18) with two inputs respectively connected to the outputs of the first and second AND gates (15, 17), the invalidation means also having at least one invalidation OR gate (19), whose inputs are respectively connected to the outputs of the output OR gates (18) of the invalidation circuits ($V_1$, $V_2$, $V_3$) and to an output of the invalidation OR gate (19) optionally supplying said invalidation signal (INVALCOMB).

5. Apparatus according to claim 3, characterized in that the invalidation means incorporate for each simulation means ($M_1$), an invalidation circuit ($V_1$) having a first AND Gate (15) with two inputs, whereof one input ($E_{11}$) can receive the simulation signal whose logic state corresponds to the failure of the corresponding component ($C_1$), the outer input of said first AND gate (15) being connected to the output (Q) of the corresponding D flip-flop (14), a second AND gate (17), whereof one input ($E_{12}$) can receive the simulation signal whose logic state corresponds to the repair of the corresponding component (C), an inverter (22) whereof an input is connected to the output (Q) of the corresponding D flip-flop (14) and whereof the output is connected to the other input of the second AND gate (15), an output OR gate (18) with two inputs respectively connected to the outputs of the first and second AND gates (15, 17), the invalidation means having at least one other OR gate (23) with inputs respectively connected to the outputs of the output OR gates (18) of the invalidation circuits ($V_1$, $V_2$, $V_3$), an output inverter whereof an input is connected to an output of said other OR gate (23), and an invalidation OR gate (25) whereof an output is connected to an input of the inverter and whereof another input is connected to an output of the interconnection means (I), an output of the invalidation OR gate (25) optionally supplying said invalidation signal (INVALCOMB).

FIG. 2

FIG.1

FIG.3